(19) Europäisches Patentamt
European Patent Office
Office européen des brevets

(11) **EP 1 264 402 B1**

(12) **EUROPEAN PATENT SPECIFICATION**

(45) Date of publication and mention
of the grant of the patent:
**15.06.2016 Bulletin 2016/24**

(51) Int Cl.:
*H03K 17/00* *(2006.01)*     *H03K 17/0412* *(2006.01)*
*H03K 17/567* *(2006.01)*     *H03K 17/687* *(2006.01)*
*C01B 13/11* *(2006.01)*

(21) Application number: **01918992.7**

(22) Date of filing: **23.02.2001**

(86) International application number:
**PCT/ZA2001/000024**

(87) International publication number:
**WO 2001/063763 (30.08.2001 Gazette 2001/35)**

(54) **DRIVE CIRCUIT AND METHOD FOR MOSFET**

SCHALTUNG UND VERFAHREN ZUM TREIBEN EINES MOSFETS

CIRCUIT ET PROCEDE DE COMMANDE D'UN MOSFET

(84) Designated Contracting States:
**AT BE CH CY DE DK ES FI FR GB GR IE IT LI LU
MC NL PT SE TR**

(30) Priority: **23.02.2000 ZA 200000887**

(43) Date of publication of application:
**11.12.2002 Bulletin 2002/50**

(73) Proprietor: **North-West University
Potchefstroom 2351 (ZA)**

(72) Inventor: **VISSER, Barend
2531 Potchefstroom (ZA)**

(74) Representative: **Jackson, Derek Charles et al
Derek Jackson Associates
The Old Yard
Lower Town
Claines
Worcestershire WR3 7RY (GB)**

(56) References cited:
WO-A1-00/50338     JP-A- H1 197 995
US-A- 4 912 335     US-A- 5 140 201
US-A- 5 475 333     US-A- 5 504 449

• MCGINTY J: "DESIGNING WITH LOW-SIDE
MOSFET DRIVERS" EDN ELECTRICAL DESIGN
NEWS, CAHNERS PUBLISHING CO. NEWTON,
MASSACHUSETTS, US, vol. 43, no. 13, 18 June
1998 (1998-06-18), pages 4-5, XP000832798 ISSN:
0012-7515
• MCGINTY, J.: 'Application note 24 - Designing
with Low-Side MOSFET Drivers"' March 1998,
MICREL INC, SAN JOSE, CA, US, pages 1 - 4

## Description

## TECHNICAL FIELD

This invention relates to a circuit and method for improving the switching speed of insulated gate semiconductor devices such as metal oxide field effect transistors (MOSFET's), more particularly power MOSFET's.

## BACKGROUND ART

Capacitance inherent in transistor junctions limits the speed at which a voltage within a circuit can switch. It is also well known that the Miller effect has an influence on the capacitance at the gate of devices of the aforementioned kind.

Prior art teaches a number of methods of alleviating the Miller effect in high frequency transistor switching circuits, for example by reducing source impedance or reducing feedback capacitance, or both.

Even with such improvements, an output of a MOSFET such as an IRF740 typically switches through 200 volts in a rise time of approximately 27ns at a peak current of 10 amperes and in a fall time of approximately 24ns. These times may be too long for many applications.

## OBJECT OF THE INVENTION

Accordingly, it is an object of the present invention to provide a triggering circuit and method for improving the rise and/or fall times of insulated gate semiconductor devices with which the applicant believes the aforementioned disadvantages will at least be alleviated.

## SUMMARY OF THE INVENTION

According to a first aspect of the present invention there is provided a method according to claim 1.

The insulated gate semiconductor device may be a metal oxide semiconductor field effect transistor (MOSFET), such as a power MOSFET.

Alternatively, the insulated gate semiconductor device may be an insulated gate bipolar transistor.

The charging pulse may raise the gate voltage of the insulated gate semiconductor device three to four times beyond a maximum rating of the semiconductor device.

The switching means may be connected between the charge storage device and the gate of the semiconductor device.

Alternatively, the charge storage device may be connected in parallel with the switching means and the insulated gate semiconductor device.

As a further alternative, the charge storage device may be connected in series with the switching means and the insulated gate semiconductor device.

The switching means may be a SIDAC.

Alternatively, the switching means may be selected from a break-over diode, a bipolar transistor, a further insulated gate semiconductor device and a high voltage fast switching device.

Electronic control means may be provided for the switching means.

The charge storage device may comprise a capacitor.

An inductor may be provided between the switching means and the gate.

Alternatively, an inductor may be connected in series with the switching means.

The circuit may be integrated on a single chip.

According to a second aspect of the invention there is provided a circuit according to claim 16.

## BRIEF DESCRIPTION OF THE DRAWINGS

The invention will now be described, by way of example only, with reference to the accompanying drawings wherein:

figure 1       is a basic circuit diagram of a triggering circuit according to the invention for a MOSFET;

figure 2       is a diagram of one embodiment of the circuit comprising a SIDAC as fast switching device;

figure 3       includes a diagram in dotted lines of gate voltage against time of normal specified operation of the MOSFET and a diagram in solid lines of operation according to the method of the invention;

figure 4       includes a diagram in dotted lines of gate current against time of normal specified operation of the MOSFET and a diagram in solid lines of operation according to the method of the invention;

figure 5       is a diagram of another embodiment of the circuit according to the invention;

figure 6       is a waveform of voltage against time at a first terminal of a charge storage capacitor in figure 5;

figure 7       is a waveform of voltage against time at the source of the MOSFET in figure 5;

figure 8       is a diagram of a triggering circuit for an insulated gate bipolar transistor;

figure 9       is a waveform of voltage against time at a first terminal of a charge storage capacitor in the circuit in figure 8;

figure 10      is a waveform of voltage against time at an emitter of the transistor in figure 8; and

figure 11      is a basic circuit diagram of yet another embodiment of the triggering circuit.

## DESCRIPTION OF A PREFERRED EMBODIMENT OF THE INVENTION

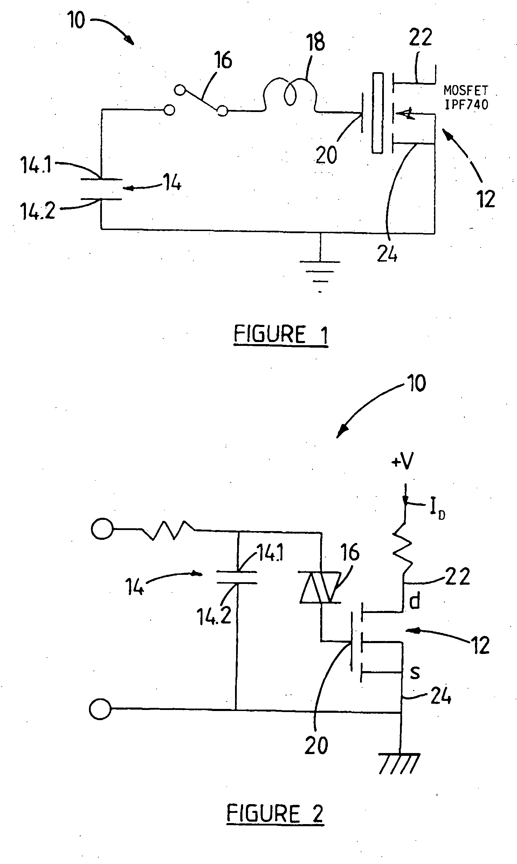

In figure 1, there is shown a basic diagram of a triggering circuit 10 according to the invention for an insulated gate semiconductor device 12 such as a metal oxide semiconductor field effect transistor (MOSFET).

In the diagram a power MOSFET is shown and which is available from International Rectifier under the trademark HEXFET number IRF740. A 10% to 90% rise time of an output voltage is specified in publicly available user data sheets of the device as being about 27ns and a corresponding fall time is specified as being in the order of 24ns. These times may be too long for some applications of the MOSFET. The turn-on delay time is specified at 14ns and the turn-off delay time as 50ns.

The triggering circuit 10 comprises a charge storage device in the form of a capacitor 14 having first and second terminals 14.1 and 14.2 respectively. The first terminal 14.1 is connected in a circuit 17 to a fast switching device 16. An optional inductor 18 is connected between the fast switching device 16 and a gate 20 of the MOSFET. The drain and source of the MOSFET are shown at 22 and 24 respectively.

The fast switching device 16 may be any suitable device having a switching speed faster than the data sheet specified turn-on delay time and/or turn-off delay time of the MOSFET, preferably better than 2ns. Such devices may include a SIDAC, a break-over diode, a suitably configured bipolar transistor arrangement, or any other suitable fast switching device or circuit.

To switch the MOSFET on, the fast switching device is switched on electronically which rapidly transfers sufficient charge from the capacitor 14 to the gate 20 of the MOSFET, to switch the MOSFET on.

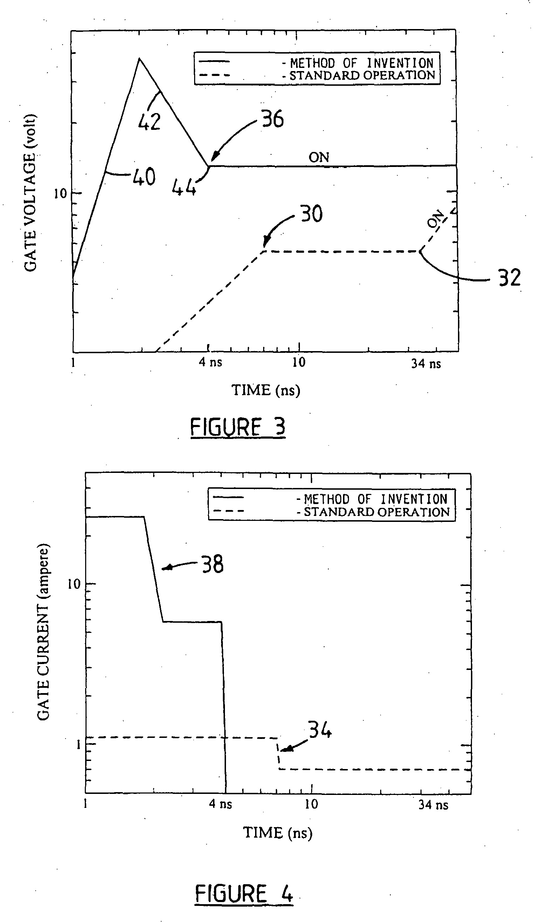

Time diagrams for the circuit in figure 1 are shown in figures 3 and 4. The diagrams in broken lines indicate normal specified operation of the MOSFET 12. Hence, diagram 30 in figure 3 shows the gate voltage of the MOSFET during conventional switching on. The MOSFET is switched on at 32 and the diagram illustrates a turn-on delay time of about 34ns. The associated gate current is shown at 34 in figure 4.

The diagrams for the method according to the invention are shown at 36 and 38 in figures 3 and 4 respectively. At 40 in figure 3, the aforementioned rapid transfer of charge from capacitor 14 through switch 16 and consequent build up of voltage on the gate of the MOSFET are shown. The subsequent fall in the gate voltage shown at 42 is attributable to the aforementioned Miller effect. What is clear though is that the device switches on at 44, after a mere 4ns. The associated current at the gate 20 is shown at 38 in figure 4. Initially, during the charge transfer stage, the gate current is high and thereafter it drops to a negligible level. It is also believed that with drain currents within the data specification of the MOSFET, switching losses with the switching method and circuit according to the invention are also reduced.

The value (C) of the capacitor 14, the voltage ($V_c$) required on the capacitor before switching and hence the breakthrough voltage of the switching device 16, the

gate threshold voltage ($V_t$) of the MOSFET 12 and the gate charge ($Q_s$) required for complete switching of the MOSFET are related according to the following equation:

$$\frac{C \, V_c}{(Q_s/V_t + C)} > V_t$$

In figure 2 a circuit diagram of the triggering circuit 10 is shown wherein the first switching device 16 is a SIDAC.

A periodic voltage is applied across a capacitor 14, in parallel with a series connection of SIDAC 16 and the gate-source path of a MOSFET 12. Initially, during a first half cycle, the voltage supplied at the input 19 is insufficient to switch the SIDAC 16 on and the capacitor 14 is hence charged up. When the supplied voltage reaches the threshold of the SIDAC 16 it switches on, resulting in a closed circuit from the capacitor 14 to the gate 20 of the MOSFET 12, partially discharging the capacitor 14 and hence charging the gate 20. The result is that a charge will now be shared between the capacitor 14 and the gate 20, so that some voltage, preferably above the gate threshold relative to ground, is applied to the gate.

Using this method, the gate voltage may for short intervals be driven approximately three to four times beyond the maximum gate-to-source voltage rating of some MOSFETs 12 without destroying the device.

Similarly, when during the other half cycle the gate voltage exceeds the reverse threshold of the SIDAC 16 and current is conducted in the opposite direction, the gate voltage of the MOSFET, 12 drops to substantially below the threshold voltage of the MOSFET 12 shortly after the charge dissipates from the gate 20 of the MOSFET 12. As a result, the MOSFET 12 will turn off and the drain current will no longer flow.

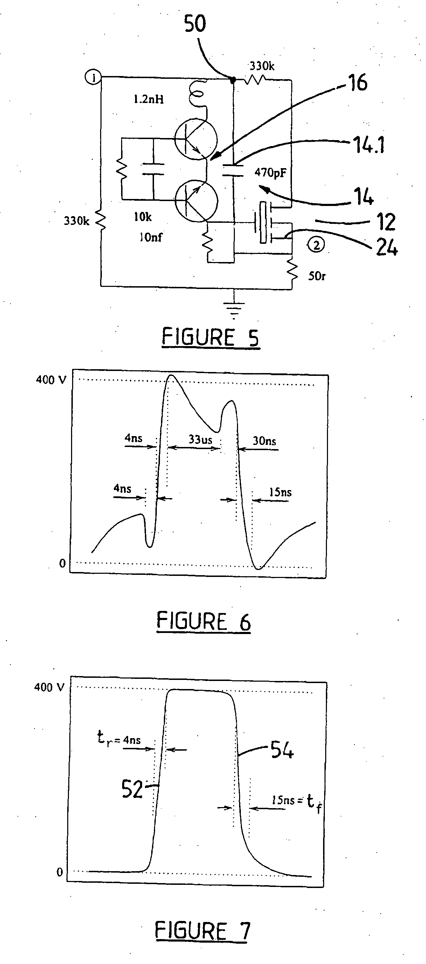

In figure 5, an alternative and self-oscillating triggering circuit for the MOSFET 12 is shown. Components thereof corresponding to components of the circuits in figures 1 and 2 are designated utilizing like reference numerals. In this embodiment, the fast switching means 16 comprises a bipolar transistor arrangement.

The voltage waveform at 50 is shown in figure 6. The voltage waveform at source 24 is shown in figure 7. From the latter waveform it can be seen at 52 that the source 24 of the aforementioned MOSFET 12 switches between an "off"-state to an "on"-state through about 400V in a rise time $t_r$ of about 4ns, which is substantially quicker than the specified rise time of 27ns. Similarly, and as shown at 54 it switches from the "on"-state to the "off"-state in a fall time $t_f$ of about 15ns, which is also substantially shorter than a specified fall time of about 24ns.

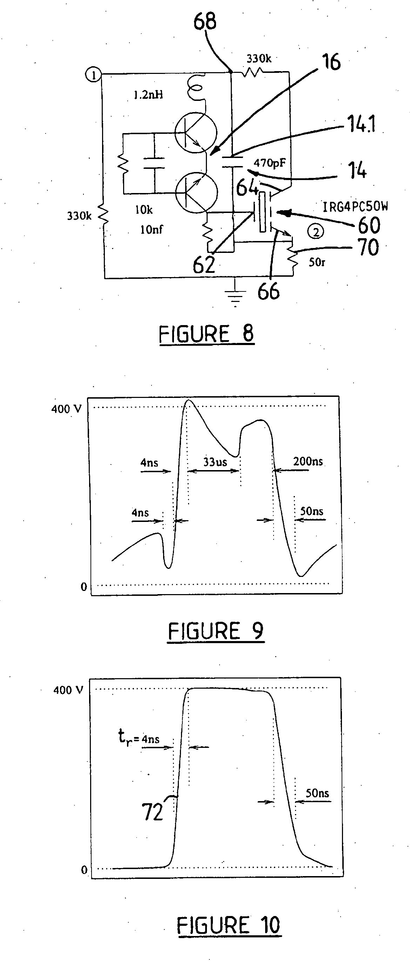

In figure 8, the same triggering circuit 10 is shown for an insulated gate bipolar transistor 60 having a gate 62, a collector 64 and an emitter 66. The transistor is an IRG4PC50W device which is being manufactured and sold by International Rectifier. The waveform at 68 in figure 8 is shown in figure 9 and the waveform at emitter 66 adjacent load 70 is shown in figure 10.

From the latter waveform it can be seen at 72 that the emitter 66 switches between an "off"-state and an "on"-state through about 400V in a rise time t, of about 4ns, which is substantially less than a specified rise time of 33ns.

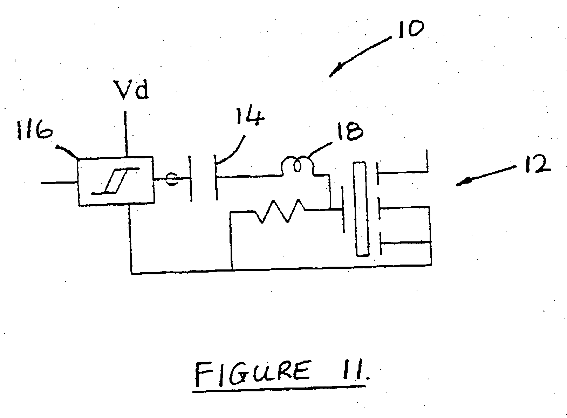

In figure 11 a further embodiment of the triggering circuit is shown. The switching means comprises a low output impedance, high voltage, fast switching driving circuit 116. The device 116 must be able to switch between OV and Vd in a first time period shorter than a specified turn-on delay time of the device 12. Vd is preferably bigger than 20xVt. Devices of this nature are available on the market.

It will be appreciated that there are many variations in detail on the triggering circuit and method according to the invention, without departing from the scope of the appended claims.

**Claims**

1. A method of using a circuit to drive an insulated gate semiconductor device (12) comprising as a first terminal a gate (20) and at least second and third terminals (22, 24), the circuit comprising a charge storage device (14) and switching means (16, 116) connected in a series circuit to the gate of the semiconductor device to apply from the charge storage device a charging pulse to the gate of the semiconductor device so as to switch the semiconductor device between one of an on state and an off state and the other of the on state and the off state, **characterised in that** the switching speed of the switching means is less than 2ns whereby the duration of the charging pulse is such that the charging pulse is complete prior to a change in the current flow between the second and third terminals (22, 24) of the semiconductor device and **in that** the charging pulse applies a voltage to the gate three to four times beyond the gate maximum voltage rating of the semiconductor device.

2. A method according to claim 1, **characterised in that** the insulated gate semiconductor device (12) is a metal oxide semiconductor field effect transistor.

3. A method according to claim 2, **characterised in that** the metal oxide semiconductor field effect transistor is a power metal oxide semiconductor field effect transistor.

4. A method according to claim 1, **characterised in that** the insulated gate semiconductor device (12) is an insulated gate bipolar transistor.

5. A method according to any preceding claim, **characterised in that** the charging pulse raises the gate voltage of the insulated gate semiconductor device (12) three to four times beyond a maximum rating of the semiconductor device.

6. A method according to any preceding claim, **characterised in that** the switching means (16) is connected between the charge storage device (14) and the gate (20) of the semiconductor device (12).

7. A method according to any preceding claim, **characterised in that** a periodic voltage is applied across a capacitor forming the charge storage device (14), in parallel with a series connection of a SIDAC forming the switching means (16) and the gate-source path of a MOSFET forming the semiconductor device (12).

8. A method according to any one of claims 1 to 6, **characterised in that** the charge storage device (14) is connected in series with the switching means (16, 116) and the insulated gate semiconductor device (12).

9. A method according to any preceding claim, **characterised in that** the switching means (16) is a SIDAC.

10. A method according to any one of claims 1 to 8, **characterised in that** the switching means (16) is selected from a break-over diode, a bipolar transistor, a further insulated gate semiconductor device and a high voltage fast switching device (116).

11. A method according to any preceding claim, **characterised in that** electronic control means is provided for the switching means (16).

12. A method according to any preceding claim, **characterised in that** the charge storage device (14) comprises a capacitor.

13. A method according to any preceding claim, **characterised in that** an inductor (18) is provided between the switching means (16, 116) and the gate (20).

14. A method according to any one of claims 1 to 12, **characterised in that** an inductor (18) is connected in series with the switching means (16, 116).

15. A method according to any preceding claim, **characterised in that** the circuit is integrated on a single chip.

16. A circuit for driving an insulated gate semiconductor device (12) comprising as a first terminal a gate (20) and at least second and third terminals (22, 24), the circuit comprising a charge storage device (14) and switching means (16, 116) connected in a series circuit to the gate of the semiconductor device to apply from the charge storage device a charging pulse to the gate of the semiconductor device so as to switch the semiconductor device between one of an on state and an off state and the other of the on state and the off state, **characterised in that** the switching speed of the switching means is less than 2ns whereby the duration of the charging pulse is such that the charging pulse is complete prior to a change in the current flow between the second and third terminals (22, 24) of the semiconductor device and **in that** the charging pulse applies a voltage to the gate three to four times beyond the gate maximum voltage rating of the semiconductor device.

## Patentansprüche

1. Verfahren zum Verwenden einer Schaltung zum Ansteuern einer Halbleitervorrichtung (12) mit isoliertem Gate, die als ersten Anschluss ein Gate (20) aufweist sowie zumindest einen zweiten und einen dritten Anschluss (22, 24) aufweist, wobei die Schaltung eine Ladungsspeichervorrichtung (14) und eine Schalteinrichtung (16, 116) aufweist, die mit dem Gate der Halbleitervorrichtung in Reihe geschaltet ist, um einen Ladepuls von der Ladungsspeichervorrichtung an das Gate der Halbleitervorrichtung anzulegen und dadurch die Halbleitervorrichtung zwischen dem einen von einem Ein-Zustand und einem Aus-Zustand sowie dem anderen von dem Ein-Zustand und dem Aus-Zustand umzuschalten, **dadurch gekennzeichnet, dass** die Schaltgeschwindigkeit der Schalteinrichtung geringer ist als 2 ns, so dass die Dauer des Ladepulses derart ist, dass der Ladepuls abgeschlossen ist, bevor eine Änderung in dem Stromfluss zwischen dem zweiten und dem dritten Anschluss (22, 24) der Halbleitervorrichtung stattfindet, und dass der Ladepuls eine Spannung an das Gate anlegt, die um das 3- bis 4-fache über der maximalen Gate-Nennspannung der Halbleitervorrichtung liegt.

2. Verfahren nach Anspruch 1, **dadurch gekennzeichnet, dass** es sich bei der Halbleitervorrichtung (12) mit isoliertem Gate um einen Metall-Oxid-Halbleiter-Feldeffekttransistor handelt.

3. Verfahren nach Anspruch 2, **dadurch gekennzeichnet, dass** es sich bei dem Metall-Oxid-Halbleiter-Feldeffekttransistor um einen Leistungs-Metall-Oxid-Halbleiter-Feldeffekttransistor handelt.

4. Verfahren nach Anspruch 1, **dadurch gekennzeichnet, dass** es ich bei der Halbleitervorrichtung (12) mit isoliertem Gate um einen Bipolartransistor mit isoliertem Gate handelt.

5. Verfahren nach einem der vorhergehenden Ansprüche, **dadurch gekennzeichnet, dass** der Ladepuls die Gate-Spannung der Halbleitervorrichtung (12) mit isoliertem Gate auf das 3- bis 4-fache über eine maximale Nennspannung der Halbleitervorrichtung anhebt.

6. Verfahren nach einem der vorhergehenden Ansprüche, **dadurch gekennzeichnet, dass** die Schalteinrichtung (16) zwischen die Ladungsspeichervorrichtung (14) und das Gate (20) der Halbleitervorrichtung (12) geschaltet wird.

7. Verfahren nach einem der vorhergehenden Ansprüche, **dadurch gekennzeichnet, dass** eine periodische Spannung über einem die Ladungsspeichervorrichtung (14) bildenden Kondensator angelegt wird, und zwar parallel zu einer Reihenschaltung eines die Schalteinrichtung (16) bildenden SIDAC und der Gate-Source-Strecke eines die Halbleitervorrichtung (12) bildenden MOSFET.

8. Verfahren nach einem der Ansprüche 1 bis 6, **dadurch gekennzeichnet, dass** die Ladungsspeichervorrichtung (14) mit der Schalteinrichtung (16, 116) und der Halbleitervorrichtung (12) mit isoliertem Gate in Reihe geschaltet wird.

9. Verfahren nach einem der vorhergehenden Ansprüche, **dadurch gekennzeichnet, dass** die Schalteinrichtung (16) ein SIDAC ist.

10. Verfahren nach einem der Ansprüche 1 bis 8, **dadurch gekennzeichnet, dass** die Schalteinrichtung (16) aus einer Kippdiode, einem Bipolartransistor, einer weiteren Halbleitervorrichtung mit isoliertem Gate und einer schnellen Hochspannungs-Schaltvorrichtung (116) ausgewählt wird.

11. Verfahren nach einem der vorhergehenden Ansprüche, **dadurch gekennzeichnet, dass** eine elektronische Steuereinrichtung für die Schalteinrichtung (16) vorgesehen wird.

12. Verfahren nach einem der vorhergehenden Ansprüche, **dadurch gekennzeichnet, dass** die Ladungsspeichervorrichtung (14) einen Kondensator aufweist.

**13.** Verfahren nach einem der vorhergehenden Ansprüche,
**dadurch gekennzeichnet, dass** eine Induktivität (18) zwischen der Schalteinrichtung (16, 116) und dem Gate (20) vorgesehen wird.

**14.** Verfahren nach einem der Ansprüche 1 bis 12,
**dadurch gekennzeichnet, dass** eine Induktivität (18) mit der Schalteinrichtung (16, 116) in Reihe geschaltet wird.

**15.** Verfahren nach einem der vorhergehenden Ansprüche,
**dadurch gekennzeichnet, dass** die Schaltung auf einem einzigen Chip integriert wird.

**16.** Schaltung zum Ansteuern einer Halbleitervorrichtung (12) mit isoliertem Gate, die als ersten Anschluss ein Gate (20) aufweist sowie zumindest einen zweiten und einen dritten Anschluss (22, 24) aufweist, wobei die Schaltung eine Ladungsspeichervorrichtung (14) und eine Schalteinrichtung (16, 116) aufweist, die mit dem Gate der Halbleitervorrichtung in Reihe geschaltet ist, um einen Ladepuls von der Ladungsspeichervorrichtung an das Gate der Halbleitervorrichtung anzulegen und dadurch die Halbleitervorrichtung zwischen dem einen von einem Ein-Zustand und einem Aus-Zustand sowie dem anderen von dem Ein-Zustand und dem Aus-Zustand umzuschalten,
**dadurch gekennzeichnet, dass** die Schaltgeschwindigkeit der Schalteinrichtung geringer ist als 2 ns, so dass die Dauer des Ladepulses derart ist, dass der Ladepuls abgeschlossen ist, bevor eine Änderung in dem Stromfluss zwischen dem zweiten und dem dritten Anschluss (22, 24) der Halbleitervorrichtung stattfindet, und dass der Ladepuls eine Spannung an das Gate anlegt, die um das 3- bis 4-fache über der maximalen Gate-Nennspannung der Halbleitervorrichtung liegt.

**Revendications**

**1.** Procédé d'utilisation d'un circuit pour commander un dispositif à semi-conducteurs à grille isolée (12) comprenant, en tant que première borne, une grille (20) et au moins des deuxième et troisième bornes (22, 24), le circuit comprenant un dispositif de stockage de charges (14) et des moyens de commutation (16, 116) connectés en un circuit série à la grille du dispositif à semi-conducteurs pour appliquer, à partir du dispositif de stockage de charges, une impulsion de charge à la grille du dispositif à semi-conducteurs de manière à commuter le dispositif à semi-conducteurs entre l'un d'un état fermé et d'un état ouvert et l'autre de l'état fermé et de l'état ouvert, **caractérisé en ce que** la vitesse de commutation des moyens de commutation est inférieure à 2 ns, moyennant quoi la durée de l'impulsion de charge est telle que l'impulsion de charge se termine avant un changement de la circulation de courant entre les deuxième et troisième bornes (22, 24) du dispositif à semi-conducteurs, et **en ce que** l'impulsion de charge applique à la grille une tension trois à quatre fois supérieure à la tension assignée maximum de grille du dispositif à semi-conducteurs.

**2.** Procédé selon la revendication 1, **caractérisé en ce que** le dispositif à semi-conducteurs à grille isolée (12) est un transistor à effet de champ métal-oxyde-semi-conducteur.

**3.** Procédé selon la revendication 2, **caractérisé en ce que** le transistor à effet de champ métal-oxyde-semi-conducteur est un transistor à effet de champ métal-oxyde-semi-conducteur de puissance.

**4.** Procédé selon la revendication 1, **caractérisé en ce que** le dispositif à semi-conducteurs à grille isolée (12) est un transistor bipolaire à grille isolée.

**5.** Procédé selon l'une quelconque des revendications précédentes, **caractérisé en ce que** l'impulsion de charge élève la tension de grille du dispositif à semi-conducteurs à grille isolée (12) trois à quatre fois au-delà d'une valeur assignée maximum du dispositif à semi-conducteurs.

**6.** Procédé selon l'une quelconque des revendications précédentes, **caractérisé en ce que** les moyens de commutation (16) sont connectés entre le dispositif de stockage de charges (14) et la grille (20) du dispositif à semi-conducteurs (12).

**7.** Procédé selon l'une quelconque des revendications précédentes, **caractérisé en ce qu'**une tension périodique est appliquée aux bornes d'un condensateur formant le dispositif de stockage de charges (14), en parallèle avec une connexion série d'un SIDAC formant les moyens de commutation (16) et du trajet grille-source d'un MOSFET formant le dispositif à semi-conducteurs (12).

**8.** Procédé selon l'une quelconque des revendications 1 à 6, **caractérisé en ce que** le dispositif de stockage de charges (14) est connecté en série avec les moyens de commutation (16, 116) et le dispositif à semi-conducteurs à grille isolée (12).

**9.** Procédé selon l'une quelconque des revendications précédentes, **caractérisé en ce que** les moyens de commutation (16) consistent en un SIDAC.

**10.** Procédé selon l'une quelconque des revendications 1 à 8, **caractérisé en ce que** les moyens de commutation (16) sont sélectionnés parmi une diode de basculement, un transistor bipolaire, un autre dispositif à semi-conducteurs à grille isolée et un dispositif de commutation rapide haute tension (116).

11. Procédé selon l'une quelconque des revendications précédentes, **caractérisé en ce que** des moyens de commande électroniques sont prévus pour les moyens de commutation (16).

12. Procédé selon l'une quelconque des revendications précédentes, **caractérisé en ce que** le dispositif de stockage de charges (14) comprend un condensateur.

13. Procédé selon l'une quelconque des revendications précédentes, **caractérisé en ce qu'**une inductance (18) est prévue entre les moyens de commutation (16, 116) et la grille (20).

14. Procédé selon l'une quelconque des revendications 1 à 12, **caractérisé en ce qu'**une inductance (18) est connectée en série avec les moyens de commutation (16, 116).

15. Procédé selon l'une quelconque des revendications précédentes, **caractérisé en ce que** le circuit est intégré sur une puce unique.

16. Circuit pour commander un dispositif à semi-conducteurs à grille isolée (12) comprenant, en tant que première borne, une grille (20) et au moins des deuxième et troisième bornes (22, 24), le circuit comprenant un dispositif de stockage de charges (14) et des moyens de commutation (16, 116) connectés en un circuit série à la grille du dispositif à semi-conducteurs pour appliquer, à partir du dispositif de stockage de charges, une impulsion de charge à la grille du dispositif à semi-conducteurs de manière à commuter le dispositif à semi-conducteurs entre l'un d'un état fermé et d'un état ouvert et l'autre de l'état fermé et de l'état ouvert, **caractérisé en ce que** la vitesse de commutation des moyens de commutation est inférieure à 2 ns, moyennant quoi la durée de l'impulsion de charge est telle que l'impulsion de charge se termine avant un changement de la circulation de courant entre les deuxième et troisième bornes (22, 24) du dispositif à semi-conducteurs, et **en ce que** l'impulsion de charge applique à la grille une tension trois à quatre fois supérieure à la tension assignée maximum de grille du dispositif à semi-conducteurs.

FIGURE 1

FIGURE 2

## FIGURE 3

## FIGURE 4

9

FIGURE 5

FIGURE 6

FIGURE 7

68

330k

16

① 1.2nH

141

470pF

14

64

IRG4PC50W

60

330k

10k

10nf

②

70

62

50r

66

**FIGURE 8**

400 V

4ns · · · 33us · · · 200ns

4ns · · · 50ns

0

**FIGURE 9**

400 V

$t_r = 4ns$

72

50ns

0

**FIGURE 10**

FIGURE 11.